# EUROPEAN PATENT APPLICATION

(11) **EP 2 813 958 A1**
(43) Date of publication of application: **17.12.2014**
(21) Application number: 13171300.0
(22) Date of filing: 10.06.2013
(51) Int. Cl.: G06F 17/50

(54) **A method and apparatus for preparation of a computational fluid dynamics model**

(71) Applicant: FUJITSU LIMITED, Kawasaki-shi, Kanagawa 211-8588 (JP)
(72) Inventor: Walker, Brent, Ealing, Greater London W13 8AB (GB); Georgescu, Serban, London, Greater London W5 3PL (GB); Chow, Peter, Gillingham, Kent ME7 3AH (GB); Kubota, Tetsuyuki, Acton, Greater London W3 0NX (GB)
(74) Representative: Wilding, Frances Ward

(57) **Abstract**

A method of preparation of a Computational Fluid Dynamics (CFD) model of a multicomponent product including a plurality of individual components for simulation, the method including providing a simplified model employing a simplified obstacle to fluid flow in place of one or more components in the model; solving the simplified model; and using the solution of the simplified model to add to modelling data by providing starting values for fluid flow in the simulation of the CFD model.

## Description

The present invention relates to computational fluid dynamics (CFD) simulation in multi-component systems. These types of simulations are a subset of Computed Aided Engineering (CAE), which is the use of computer software for the purpose of modelling and simulating the behaviour of products in order to improve their quality.

CFD is a branch of fluid mechanics that uses iterative numerical methods and algorithms to solve and analyse problems that involve fluid flows. A solution may be a steady state or a transient state of fluid flow. CFD can also take heat flow into account, and thus act additionally as a heat analysis.

The invention particularly relates to the field of CFD simulations which involve a large number of models composed of a finite number of components. A typical application is CFD simulation of heat transfer inside servers, in which the model usually consists of one large component (Motherboard) and many smaller components (expansion cards, memory modules, CPUs, etc) and several configurations need to be simulated and analyzed.

CFD simulation has become a crucial step in the design of many industrial products. One typical case is the information technology IT industry, where hardware manufacturers and system integrators use CFD to simulate the air flow and heat transfer inside notebooks, desktops, computers, servers and other IT devices. The results obtained from the CFD simulations are used to increase the quality and reliability of the products by optimizing the way the components are placed inside the case and making sure they are running at optimal temperature. On a larger scale, the same kind of simulation can be used for the many parts in an automobile or aircraft. CFD can also be used for simulation of data centres and rooms within data centres.

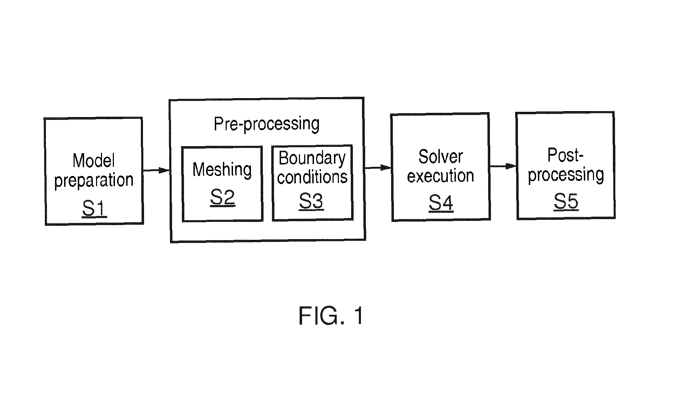

The flow of a traditional CFD simulation process is shown in Figure 1. First, a CAD model of the system to be simulated is created or obtained in step S1. Before the simulation can be performed, the model has to undergo pre-processing, in which a mesh of the model is created in step S2 and then boundary conditions and material properties are set in step S3. In meshing, the geometry is partitioned (meshed) by a mesher into a very large number of elements, to form a mesh. The mesh, accompanied by the boundary conditions, is subsequently sent to a solver which uses standard numerical techniques, like the Finite Element Method, or, more usually, the Finite Volume Method to compute the effect (e.g. fluid behaviour and properties) of the boundary conditions on the system, using individual calculations for each element. For complex geometries with many components, the meshing stage is particularly difficult both from a computational point of view and because in many instances it involves manual work.

After the pre-processing stage has been completed, the CFD solver mentioned above is run in step S4 in a simulation/modelling stage which solves the numerical equations, generally using an iterative technique to obtain the results of the simulation. The process ends with a post-processing stage S5, in which the results are visualized and analyzed.

Embodiments of the invention aim to address the computing and/or user input time required to simulate complex CFD models, in particular for models that are a combination of a number of components.

According to an embodiment of an aspect of the invention there is provided a method of preparation of a Computational Fluid Dynamics (CFD) model of a multi-component product including a plurality of individual components for simulation, the method including: providing a simplified model employing a simplified obstacle to fluid flow in place of (a full representation of) one or more components in the model; solving the simplified model; and using the solution of the simplified model to add to modelling data by providing starting values for fluid flow in the simulation of the CFD model.

Thus in a simplified model used for preparation purposes only, some or potentially all the components of the CFD model of a product are replaced with simplified obstacles to fluid flow. Using an obstacle rather than the full representation of the component allows a process approximately modelling a product, to a degree of accuracy which gives an idea of what fluid flow might be in the unsimplified model. This estimate of fluid flow can give starting values for the unsimplified model that are thus close to the final model solution. Convergence of the fluid dynamics to find a solution is a significant part of the computing time required for modelling and thus reduction of convergence time makes a considerable difference to modelling efficiency.

The preparation method may be triggered by specific user input, or may be carried out automatically without user input, for example if a simplified obstacle to fluid flow for replacement of a component used in the model is available to the computer system carrying out the modelling. In one embodiment, the provision of the simplified model and simplified model solution are carried out automatically when the multi-component product model is built.

Another embodiment relates to meshing of the CFD model. A single mesh may be used for the entire model, or separate meshes may be provided for each component (or possibly each group of components, when some or all of the individual components are grouped together in the modelling process). In many embodiments, the model is meshed using a compound mesh comprising a background mesh and separate meshes for the components, and the starting values for fluid flow are for background mesh flow.

In the prior art approach to CFD simulation a monolithic model of the entire system is developed. A single mesh describing the system is generated and the pertinent equations (e.g. Navier-Stokes, heat equations) are solved. Although many solvers are available for this purpose, expert-level CFD knowledge is usually required to build the model. This is especially apparent when a computational mesh for the model is created.

In unpublished related art by the same inventors (European Patent Application 13161198.0, which is incorporated herein by reference), an approach for creating a "Multi-component CFD solver" was described. The idea underlying this approach, and used in many invention embodiments, is that components from a pre-built library are combined to set up the model. Individual components are selected from the library, and pieced together via a background mesh, which provides the medium for data exchange between the components. Being able to combine well-studied components reduces the level of CFD expertise needed to set up and perform a simulation, as much of the required expert knowledge is embedded in the library components during their creation.

Numerically it is expected that converging the fluid dynamics of the background mesh via coupling iterations is a difficult part of a calculation in the multi-component CFD system of the related art, and is expected to account for a considerable amount of the overall computational work. If the flow in the background mesh can be made roughly correct before the coupling iterations begin, the primary work required in the coupling iterations will be to include the effects of the fine details of the components. Removing the need for the broad features of the flow in the background mesh to emerge from the coupling iterations will save a considerable amount of computational time in the overall coupled simulation.

Embodiments of the invention can obtain a good starting point for running a calculation with data exchange between multiple components. This will improve the stability of the coupling (data exchange) part of the calculation, as much of the effect induced by the components is included from the outset. As the starting flow in the background mesh is closer to the converged flow, the number of coupling steps required for convergence will be reduced.

The compound mesh is built from a collection of mashes, with information transferred between them and may be an "assembled" or embedded mesh as discussed in more detail later, or a coupled mesh, as used in the multi-component approach of the related art.

The simplified model may also use a compound mesh, and is preferably meshed using at least a background mesh and solved by iterative calculations, with the background mesh solution providing the starting values for fluid flow in the CFD full model simulation.

The starting values for fluid flow in the CFD model simulation may be interpolated onto the boundaries of the component mesh from the background mesh of the simplified model. This can thus be used to provide boundary conditions for the component when the modelling starts.

The simplified obstacle may be created at the time when the model is made, or previously. A library as proposed in the related art can be used to store components used in a range of multi-component products along with their modelling properties. Thus the library can include expert knowledge needed, for example, for meshing and alternative products including the components may be created without the need for individual component meshing or expert knowledge. The library, probably in the form of an electronic database, may store not only individual components with their component mesh, but also one or more designs, design suggestions, or instructions for creating one or more simplified obstacles for some or all of the components (simplified obstacles may not be appropriate/advantageous for some less-complex components).

Thus in some embodiments, the simplified obstacle is stored before the multi-component product model is built, with the component and a mesh for the component and optionally any mesh required for the simplified obstacle.

The background mesh for the simplified model is created at the time the simplified model is created. It may be a standard mesh, or specially adapted. In some embodiments, the background mesh is refined during the provision of the simplified model to contour around the simplified obstacle so that the background mesh more faithfully represents the simplified obstacle (than a standard mesh or than before refinement), wherein for finite element simulation, the refinement is local to the simplified obstacle. The refinement may be part of background mesh creation, or comprise a subsequent step.

One concept in invention embodiments is to create a simplified representation of the overall model by filling the regions of space occupied by each component in the multi-component simulation with something simpler (a simplified obstacle to fluid flow), which when solved will provide an advantageous starting point for the coupled simulation. There are several possible different approaches, for example using a void, a replacement component, a flow resistance or an internal boundary condition. Thus it will be appreciated that the obstacle to fluid flow need not be a solid object.

In one embodiment, the simplified obstacle comprises a mesh void, the mesh void preferably encompassing the component. The void may thus lie entirely within the component mesh but outside the solid part of the component itself.

Advantageously, the mesh void is formed by encapsulating the component in a solid geometric shape and using the solid geometric shape to create the void.

A simplified obstacle may alternatively comprise a replacement component with a simpler geometry than the component geometry, the replacement component preferably covering a part only of a component mesh.

The replacement component may also include one or more thermal properties and advantageously includes simplified thermal properties representing more complex thermal properties of the component in the model, such as an average heat capacity equivalent to that of the component in the model.

There may be more than one simplified obstacle provided for a component, for example a void, and a replacement component. Different simplified obstacles may be suitable for different analyses, for example depending on whether thermal properties are to be taken into consideration. In this case, two or more simplified obstacles may be stored with a single component in the library mentioned previously. The choice between the simplified obstacles may be automatic or made by user input.

Although in the simpler examples, a single component is replaced by a single replacement component, any components comprising more than one sub-component may be replaced by a single replacement component or single mesh void. This type of replacement may also be stored in the library.

In contrast to the mesh voids, replacement components require meshing, and thus the simplified model may be meshed using a compound mesh comprising the background mesh and a separate mesh for each replacement component.

For both the void and the replacement component, an initial velocity boundary condition of zero velocity may be set on the edges for solution of the simplified model.

According to an embodiment of a computer program aspect, there is provided a computer program which when executed carries out any of the methods defined above.

According to one embodiment of a further aspect of the invention there is provided a computer apparatus arranged to implement a method of preparation of a CFD model of a multi-component product including a plurality of individual components for simulation, the apparatus including: a model simplifier arranged to provide a simplified model employing a simplified obstacle to fluid flow in place of each of one or more components in the model; at least one initialisation solver arranged to solve the simplified model; and a data inputter arranged to use the solution of the simplified model by adding starting values for fluid flow to modelling data for the simulation of the CFD model.

According to one embodiment of a yet further aspect of the invention there is provided a computer apparatus arranged to implement a method of simplifying CFD pre-processing for a range of multi-component products, each product including a different combination of a plurality of components provided for the range, the computer apparatus including: an input for a Computer Aided Design CAD model of component geometry; a library interface and library processor allowing a library user to add an air region around the component; to create a mesh including the component and its surrounding air region for use in CFD analysis; and to create a simplified obstacle to fluid flow for use in an initialisation process to provide starting values for fluid flow by solving a simplified model in which components have been replaced by simplified obstacles; and a component library individually storing known components for the range in a database, each known component comprising the component geometry, mesh and simplified obstacle, wherein the component library allows selection and placing of the known components to create models of the products.

When the simplified model and the full model are both required, either the simplified model or the full CFD model may be provided first, or they may be created simultaneously, depending on implementation details. Both require selection and placing, of the simplified obstacle or of the component respectively.

In any of the above aspects, the various features may be implemented in hardware, or as software modules running on one or more processors. Features of one aspect may be applied to any of the other aspects.

The method aspects are intended for computer implementation and the individual components defined in the system and apparatus aspects may comprise processors and memory in combination with code arranged to execute on the computer hardware to provide the components defined.

The invention can be implemented as a computer program or computer program product, i.e., a computer program tangibly embodied in a non-transitory information carrier, e.g., in a machine-readable storage device, or in a propagated signal, for execution by, or to control the operation of, one or more hardware modules. A computer program can be in the form of a stand-alone program, a computer program portion or more than one computer program and can be written in any form of programming language, including compiled or interpreted languages, and it can be deployed in any form, including as a stand-alone program or as a module, component, subroutine, or other unit suitable for use in a data processing environment. A computer program can be deployed to be executed on one module or on multiple modules at one site or distributed across multiple sites on the vehicle or in the back-end system and interconnected by a communication network.

Method steps of the invention can be performed by one or more programmable processors executing a computer program to perform functions of the invention by operating on input data and generating output. Apparatus of the invention can be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions coupled to one or more memory devices for storing instructions and data.

The invention is described in terms of particular embodiments. Other embodiments are within the scope of the following claims. For example, the steps of the invention can be performed in a different order and still achieve desirable results. Multiple test script versions can be edited and invoked as a unit without using object-oriented programming technology; for example, the elements of a script object can be organized in a structured database or a file system, and the operations described as being performed by the script object can be performed by a test control program.

The apparatus according to preferred embodiments is described as configured or arranged to carry out certain functions. This configuration or arrangement could be by use of hardware or middleware or any other suitable system. In preferred embodiments, the configuration or arrangement is by software.

Elements of the invention have been described using the terms "inputter" and "simplifier" and other functional terms. The skilled person will appreciate that such terms and their equivalents may refer to parts of system or apparatus that are spatially separate but combine to serve the function defined. Equally, the same physical parts of the computing system or apparatus may provide any two or more of the functions defined.

For example, separately defined parts may be implemented using the same memory and/or processor as appropriate.

Reference will now be made, by way of example, to the accompanying drawings showing the prior art and embodiments of the invention in which:
Figure 1 (described above) is a flow chart of a prior art CFD simulation;
Figure 2 is a general flow chart according to invention embodiments;
Figure 3 is an overview of how the simplified model is used in an improved CFD simulation;
Figure 4 is a more detailed view of how the simplified model is integrated in a CFD simulation;
Figure 5 is a 3D representation of a simple model to be simulated;
Figure 6 is a 3D representation of different scenarios to be simulated and their meshes;
Figure 7 shows the creation of a void corresponding to one component as a simplified obstacle;
Figure 8 shows the creation of a void corresponding to another component as a simplified obstacle;
Figure 9 is a comparison of rates of convergence for a zero initialization, a large void initialization and a small void initialization; and
Figure 10 shows the creation of a simple solid as a simplified obstacle.

The scope of this invention is in the field of CFD simulations, especially those involving a large number of discrete components. The main target application is IT hardware design, where a typical piece of equipment consists of many components of different sizes, shapes and thermal characteristics attached in different arrangements to a base board, with air flowing around the components to cool the assembly. A multi-component approach can significantly improve the efficiency of CFD simulations of such systems over the standard monolithic approach. The enhancement described herein further improves the computational efficiency of that simulation system.

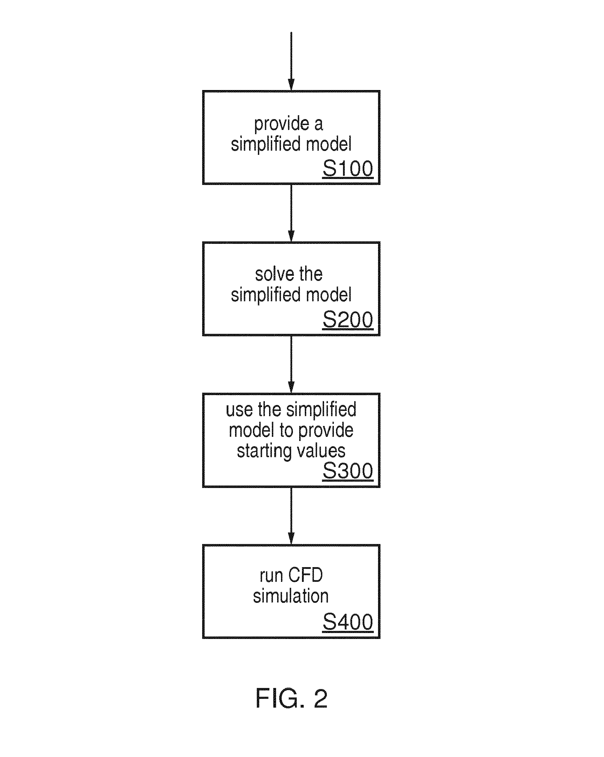

Figure 2 shows an overview of some invention embodiments in the form of a flow chart. In step S100, a simplified model is provided. For example the model may use one or more simplified obstacles, which may be created on-the-fly or retrieved from a database.

In step S200, the simplified model is simulated, to find a solution, for instance a steady state fluid flow and potentially also heat flow.

This solution is used to provide starting values for the simulation of the full CFD model, in which no components are simplified, in step S300.

The full simulation may then be executed in step S400.

In a CFD simulation of airflow, for example across a server, the components generally act as obstacles to the flow. In terms of the flow, a large part of the influence on the CFD in the fluid part of the domain is due to the presence of the component, rather than the detailed characteristics of the component itself. The detailed characteristics of the component will often be secondary to the fact that a component of that size is present. The details, e.g. the fine-grained geometry of the component, are expected in most cases to represent smaller perturbations on top of the larger perturbation of having, for instance, a block of material present in the flow.

When performing a coupled calculation, with data exchange between different components/component meshes and a background mesh, the starting guess for the flow properties (e.g. the fluid velocity) may not represent the final solution well (for instance, if starting with zero velocity, or the uniform velocity distribution typical of flow through an empty chamber). In this case, much of the work in performing the data exchange may in fact be used in establishing the larger scale characteristics of the fluid flow in the background mesh.

As the coupling steps may well be the bulk of the work required in performing a coupled multi-component CFD calculation, reducing the number of coupling steps required, both by providing a starting point "closer" to the final converged solution, and improving the stability (if we have smaller oscillations, we will need fewer coupling steps to reach convergence) will provide a significant reduction in simulation time.

The inventors believe that it is desirable to address the large number of iterations that may be required to establish the flow around the components in a multi-component CFD simulation. Particularly for the case in which the components in the multi-component simulation are solid parts, we can develop a good computational starting point for the simulation using a version of the overall system in which the components are replaced by much simpler obstacles to the flow.

Some more detailed design considerations are set out below.

The full model and simplified model need not be created in any particular order; and they may even be created in parallel rather than sequentially. In one example, it is possible to make the simplified model first, and the data calculated there could then be used for initializing a full model created later, provided that the full model is consistent with the simplified model. Choosing and placing the components may be viewed as making a "model template". Which representation of each component ("simple" or "realistic") is used in the simulation can determine the level of model being simulated. In the case of generating the initialization data, the "simple" versions of the components (the obstacles) would be used. After that incarnation is solved, the resulting data could be used for initialization of a simulation in which the components were replaced by their "realistic" representations.

In a variant, one simplified starting model can be used to initialize different full simulations in a situation when considering several models that are variations of one another. As long as the full model is sufficiently consistent with the simplified model, the solution of the simplified model should provide advantageous initialization information for solution of the full model.

The different types of simplification mentioned above could be used together within the same model, for instance one part could be replaced by a void and another could be replaced by a simpler solid component. A major reason to use a solid instead of a void would be if one required inclusion of thermal effects for that component. With replacements of different types for different components, the thermal effects of one component and not the other could be included. In the case of replacing a component with a void, there is a computational advantage during solution of the simple model, as there are simply no points within the void; the downside in that case is that refinement of the background mesh is often required.

Boundary data for the components in the full model can be obtained by interpolating directly from the (background) mesh in the simplified model. It is advantageous to interpolate the data from the simplified model onto the background mesh of the full model, and from there onto the components of the full model. This helps keep the initialization as a separate step from solution when dealing with the full model. The background mesh in the simplified model will generally be strictly different between the simplified and full models; for instance, if the void-replacement strategy is being used, the "background" mesh in the simplified mesh will have holes (and optionally refinement around them), which will not be present in the background mesh appearing in the full model.

It is possible to simplify some components but not others, but any non-simplified components could potentially result in there being significant refinement of the background mesh in meshing the simplified case, which may reduce the advantages of the method. With a mix of complicated and relatively simple components in the full model, it might be the case that only the complicated component(s) need be replaced (the simpler component(s) is already simple, so there is no expectation of a significant improvement if it is replaced).

This invention improves the rate of convergence for a multi-component CFD system, such as that described in the related art. In that related art, a system is described in which a CFD model is built by selecting components from a pre-built library. The components are simulated separately, with data being passed between them via a background mesh to establish the properties of the overall system. In performing a calculation using a multi-component CFD system, a starting condition for the flow in the background mesh is necessary. The flow in this background mesh will be established as the components exchange information.

Invention embodiments are concerned with the part of the calculation between the "Model preparation" and "Pre-processing" stages shown in Figure 1. Including the improvements of an invention embodiment, setting up a calculation may involve the following steps:
1. Create a multi-component model, encompassing the components and the background domain (as in the related art)
2. Make a simplified model for a CFD solution, by replacing the components with simpler representative components (this can be automatic);
3. Solve the simplified CFD model to obtain a starting guess for the flow in the background mesh (this can also be automatic);
4. Proceed with the simulation.

In a non-coupled simulation with embedded meshes, Steps 2 and 3 above can be implemented in a CFD with multi-component capabilities, such as the Overture CFD code. As a result of the simplification process, the simplified model may also be amendable to a "single CFD solution", in which the model resulting from the simplification process is not considered as a collection of coupled parts; there is no iterative transfer of data between coupled components during the solution of the simplified model. Advantageously, the simplified model is sufficiently simple that its solution can be reasonably easily computed using a standard monolithic solver.

This invention is concerned with the automatic generation and solution of the simplified model, i.e. Steps 2 and 3, in the above list. After the multi-component model is built, components in the model are replaced by simplified versions of themselves. If using a system such as that described in the related art, the details of how simplification of a component should be made can be contained within the component library, meaning the expert knowledge regarding what replacements are acceptable for that component can be accumulated there and need not be provided again by the user.

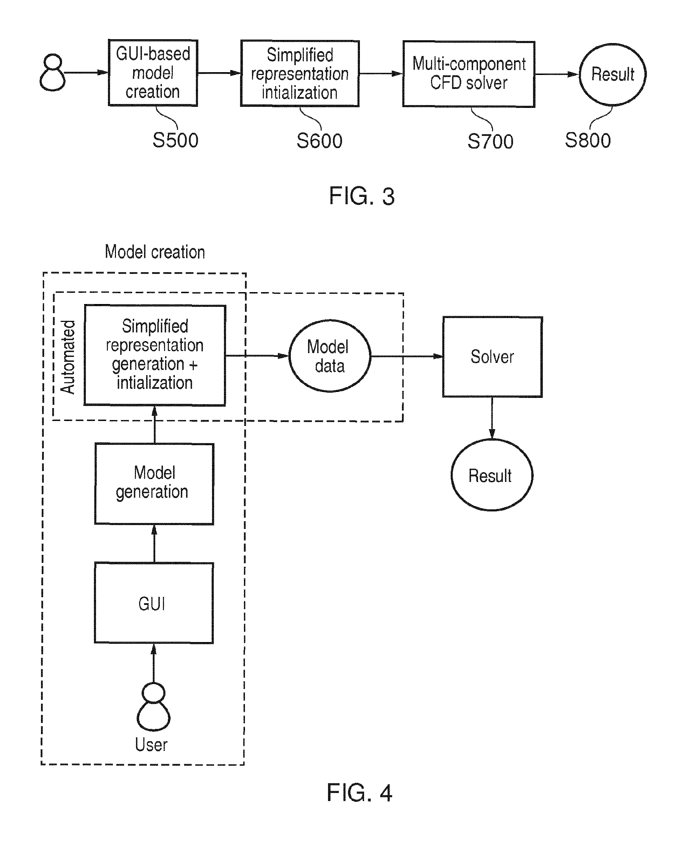

Figure 3 depicts a flow chart showing how the model preparation of invention embodiments can be integrated into a multi-component CFD simulation methodology.

A first stage of multi-component CFD simulation methodology (not shown) may be the library creation stage, where basic components of the model are prepared for the simulation (i.e., various properties as heat sources, flow rates, material properties and so on are added), meshed in isolation, and then added to a component library database. A library processor is required for this stage. A library user interface is also usually required. While the process is usually a manual one requiring a user interface, it can also be automated. Regardless of how this process is performed, this stage can have several key aspects:
- it has to performed only once per component
- all properties for each component are saved in the library together with the geometry
- expert knowledge in the form of mesh resolution, amount of surrounding air, properties, etc is accumulated in the component library

For the simplified model, one or more simplified obstacles for each component can be prepared and stored within the database as part of the information pertaining to that component, including all the necessary properties and meshing for use in the simplified model simulation.

Alternative simplifications can be stored, for example corresponding to different levels of simplification, or providing options suitable for different cases (e.g. a void in one case or a replacement solid in another, depending on whether inclusion of thermal properties are required for the simulation under consideration). A replacement shape "closer" to the actual component might be offered, but using such a component would require more work in performing the initialization. The alternative simplifications for a particular component would be tested and placed into the library by the experts developing the system.

The second stage of multi-component CFD simulation methodology is GUI-based model creation. In the example shown, the full model is created before the simplified model. A user employs a GUI-based environment (potentially linked with the library) and a processor (and memory to store the model during and after creation). In step S500 a GUI is used to create the model to be simulated by choosing and placing components from the previously populated component library. After the components are selected and boundary conditions are set, the models are automatically combined by a model generator in the system and modelling data (the input data for the solver) is created without user intervention. The key aspects of this stage for a multi-component approach can be:
- no meshing is required
- no properties (e.g., material, internal boundary conditions, etc) need to be set, however they can be updated by the user if needed
- created models can themselves be added as components to the component library

A new stage of simplified representation initialization is added at step S600. Here the simplified model is created and then solved using one or more CFD solvers as detailed herein.

The next stage is the solver stage for the full CFD model of step S700. There are three options for the solver stage. In one option, the combined model undergoes a knitting process to form a single mesh and a "standard" monolithic solver is used for the simulation. In a second option, an overlapping or embedded mesh approach is taken, using "Overture" or another more complex monolithic but single solver suitable for solving problems on a collection of structured grids (by transfer of information between the grids).

In a third option, a multi-component CFD solver according to the related art is provided, with one solver per component or instance of a solver used per component. Instead of running the simulation as one monolithic model and executing only one instance of the solver, multiple solvers are executed, one for every component or for a group of components. It is also possible to run multiple solvers for just one single component. Coupling technology is used to exchange data between the multiple solvers so that the final results match the ones for the original, monolithic simulation. The multi-component solver may use a scheduler managing a time of action of each solver and data exchange between the solver. The key aspect of this variant is that it is computationally efficient on modern computer architectures.

In this, and the other embodiments, a single computer system can provide functionality for all the stages, or the processing in each stage can be carried out by a separate computer system, with data transfer between the stages. For example, the library creation may be carried out by a specialist CAE firm, the model creation and simplification initialization by a design and manufacturing firm and the final simulation and solvers may be hosted on a cloud so that each stage involves a separate computing system, run by a separate commercial entity. Alternatively, all the stages may be executed within a single system.

Figure 4 depicts the overlap between model creation, shown as a flow chart block to the left, and automated processing, shown as a top flow chart block. The simplified representation generation and initialization is an automated part of the model creation. Here and elsewhere, initialization refers to solution of the simplified model to provide model data for the full CFD simulation. Thus the model data is also created automatically although all of these proceses can be made amenable to fine-tuning by expert/advanced users should they so desire.

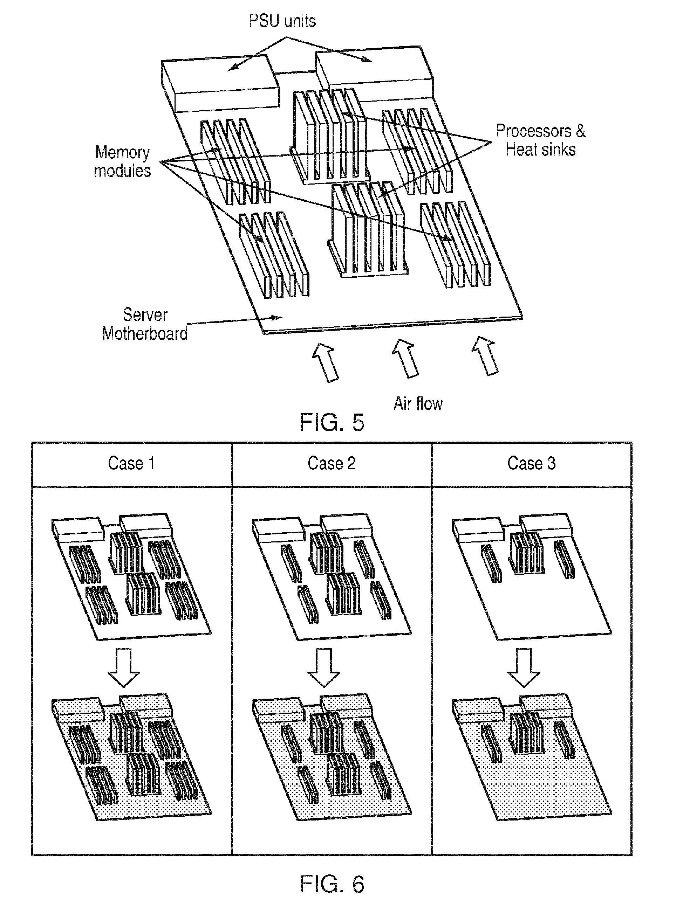

Computational fluid dynamics is widely used in industrial design. It is especially important in the case of computer equipment, where elements of various size and complexity are arranged together, generally on top of a system motherboard. Some or all of the elements (e.g. a CPU or GPU) may produce heat, and the assembly will generally be subject to cooling air flow over it. The relative placement of the components can have important effects on the cooling characteristics of the airflow: changing the arrangement of the components may allow better airflow and better cooling of the components, which can increase their reliability, and in turn that of the overall system. Performing CFD simulations allows assessment of different configurations at the design stage, providing useful input to the prototyping stage. A "basic" server model is shown in Figure 5, where the model to be simulated consists of a server motherboard equipped with two power supply units (PSUs), 16 memory modules (in groups of four), and two processors with heat sinks (a production model would comprise many more components than the model depicted). According to the prior art, a mesh for the entire model is created after the CAD model has been created/loaded.

Different combinations of the PSUs, memory, and processor components result in different overall configurations that need to be modelled, for instance, as illustrated in Figure 6: a high performance - large memory configuration (Case 1), a high performance - lower memory configuration (Case 2) and a low performance - low memory configuration Case 3). All these cases need to be simulated and, in the traditional approach, all models need to meshed from scratch.

It is valuable to be able to rapidly study such variations in the configuration. The related art and some invention embodiments improve upon the standard method of performing monolithic CFD simulations, in particular through a component library and the introduction of clear avenues for parallelism. In such a multi-component system, many coupling iterations may be required to converge the flow in the background mesh, as that flow must emerge via the data exchange between the coupled components.

An appropriate background mesh depends on the application at hand. A suitable background mesh is one which allows convergence of the (full) simulation; in particular, it needs to be able to resolve the details of the flow around the components. The knowledge required to construct robust default background meshes may be included in the CFD system by the expert developing it. Alternatively or additionally, the system can allow an experienced CFD practitioner using the system to make their own choices for the details of the background mesh should they so desire.

Two preferred ways of replacing the model components to develop the "simplified" representation and reduce the number of iterations are now discussed:
1. Each component is replaced by a void encompassing the internal solid part of the component (the physical solid, without any air buffer). Appropriate parts of the mesh are then automatically removed from the mesh, resulting in a background mesh containing voids. The flow though this mesh is solved, and used as the starting point for the coupling iterations.
2. Each component is replaced by a simpler component. If a component contains complicated sub-parts or parts with fine geometrical details, it can be replaced with a single simpler geometrical shape.

The simpler part may also have simpler thermal properties, such as representative thermal properties, for example a solid block having the same average heat capacity as the true (detailed) component. Different sub-parts of the solid could have different thermal characteristics, e.g. heat capacity. A good example would be a solid consisting of several metals joined together. The simplification could then involve replacing a part which has several subparts (possibly with different heat capacities), with a single part with effective thermal properties. The details of the simplification of the thermal characteristics of the solid may be included in the library mentioned previously by an expert developing the library.

### (1). Void creation

In this version of creating a simplified overall model, after the required components are selected from the component library, the extent of the background mesh determined and the background mesh generated, the parts of that mesh where the components sit are replaced by voids, i.e. points are removed from the background mesh. This is performed automatically by the simulation system. If the CFD solver being used supports it, refinement of the background mesh can be made so that the void created faithfully represents the desired shape.

Several strategies for creating the void are possible. Firstly, the complicated solid part of the component could be removed directly. If the mesh is then refined around the void, the background mesh will follow the part closely, including its fine details. This however will mean that the new background mesh may contain many mesh points, and the time required to generate the background mesh will be comparable to that required to generate the component mesh itself. Another strategy would be to remove the volume occupied by the whole component mesh. This may result in voids which are large and/or do not have shapes similar to the solid parts of the components being replaced. An intermediate strategy, which it is believed provides a favourable compromise between these two strategies, is to encapsulate the solid part of the component in a suitable simpler geometric shape and use that for creating the void in the background mesh.

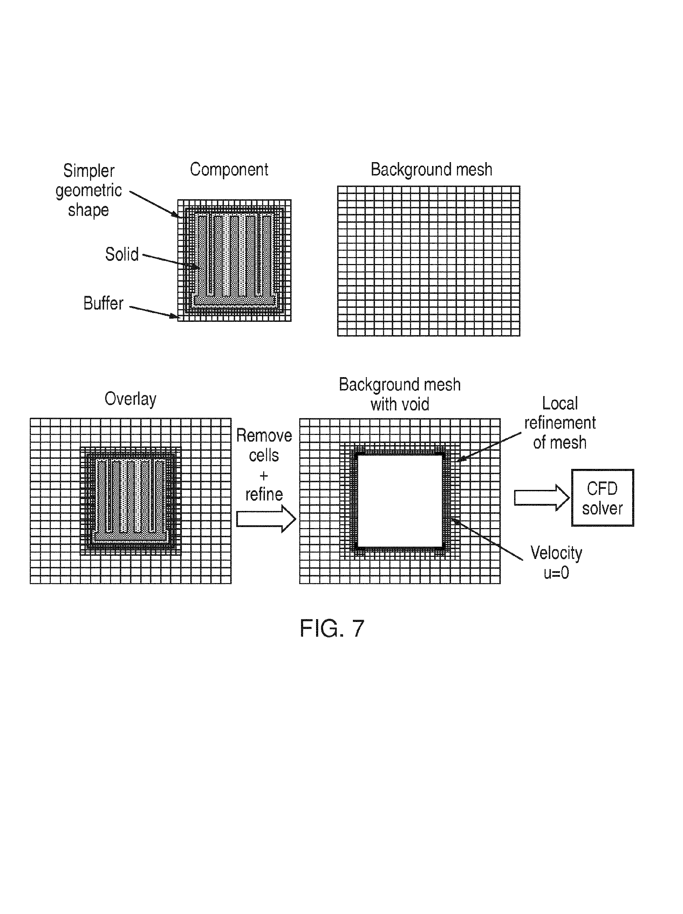

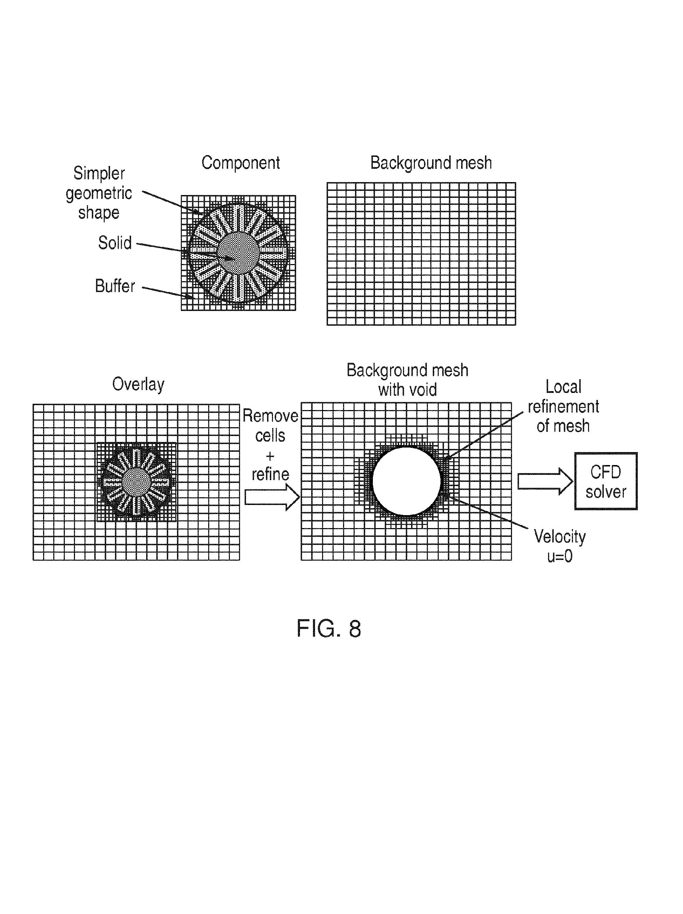

The process is illustrated in Figures 7 and 8 for representative components. A component (solid part plus its associated mesh) and the background mesh are shown in each figure. The solid part is in each case surrounded by a simpler geometrical shape. The component is overlaid onto the background mesh, and the cells in the background mesh which overlap with the simple shape are removed. Depending on the CFD solver, refinement of the background mesh can then be made near the void. The velocity boundary condition u = 0 will be set on the edges of the void.

In general, whether the "refined" background mesh is literally refined from an "unrefined" background mesh or whether this mesh is generated in one step depends on the mesher being used. In the OpenFOAM mesher (snappyHexMesher), the refinement process starts with a structured mesh with simple formulae for the cell lengths along the bounding axes (e.g. uniform), and then refines this to include the geometrical features required, such as a void or solid. In the case of Gmsh, the mesh for the model with the void, including sufficient detail around the void, is generated in one shot. Creation of the background mesh should incur a small computational cost, so is performed after the components have been chosen for the model. The data from the solution of the simplified model is interpolated onto the background mesh in the coupled simulation of the full/complicated model.

For the example cases shown in Figures 7 and 8, the number of grid points and mesh generation time for the component mesh, original background mesh, and the background mesh containing the void are shown in Table 1.

The data shown refer to three dimensional versions of the two-dimensional slices shown in Figures 7 and 8. Cell lengths along the third dimension are comparable to those in the other dimensions. The component meshes are generated once and stored in the library, but the background meshes are generated on a per-simulation basis, so it is important that their generation does not incur an unreasonable computational penalty.

In the cases shown, the number of points and the generation time for the background mesh with void (though larger than those for the original background mesh) are significantly smaller than those for the component mesh. The ratio between the number of points in the background mesh with void(s) (or its generation time) and the component mesh(es) (or their generation time) is expected to become smaller as more components are added to the simulation. This ratio is also expected to decrease as the solid part of the component becomes more complicated. It should be noted that the examples shown are much smaller than those expected in production applications; as larger/finer meshes are considered, the ratios discussed will become more favourable still.

| | Number of mesh points | Mesh generation time [s] |
|---|---|---|
| **Figure 7** | | |
| Component mesh | 321039 | 91.652 |
| Original background mesh | 8400 | 0.126 |
| Background mesh with void | 76423 | 19.84 |

| **Figure 8** | | |
|---|---|---|
| Component mesh | 307284 | 251.462 |
| Original background mesh | 8000 | 0.132 |
| Background mesh with void | 31527 | 9.598 |

The boundaries of the component mesh are outside the void created in the background mesh, so the flow properties there can easily be interpolated from the calculation of the flow in the background mesh, to provide boundary conditions for the component simulation when starting the coupled simulation. To transfer data from the background mesh, values are interpolated onto the edges of the component mesh (this can always be done as all the points on the boundary of the buffer region of the component are within the fluid part of the background mesh).

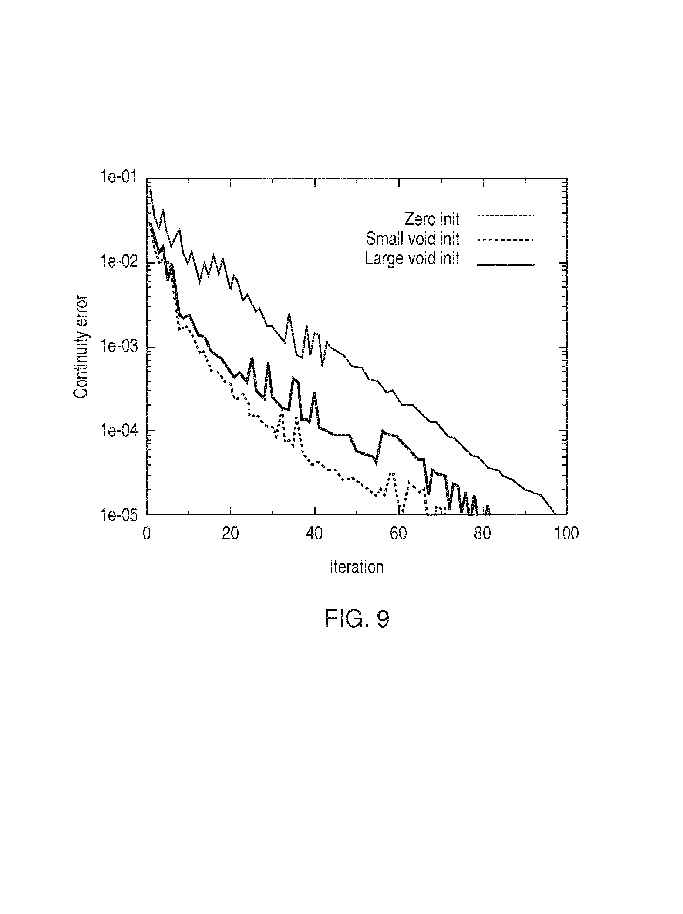

As an illustration of how the void-based initialization strategy proposed here improves convergence of the flow around a component, we apply the strategy to calculation of the flow around a single block (in a monolithic CFD calculation). We compare the rate of convergence (quantified by the continuity error, which is related to the overall convergence of the flow) in Figure 9. Three ways of initializing the flow are considered. In the first case, the velocities are initially zero in the chamber ('Zero init'); in the second case, we use the void initialization strategy with a void with boundaries close to the block ('Small void init'); in the third case, we use the void initialization strategy with a larger void ('Large void init'). The elements in the grid are the same size in all cases, and the block and voids occupy an exact number of cells in the mesh in each case, so no refinement of the background mesh is performed when the voids are created and no interpolation is needed when initializing calculation of the flow around the block with the flow around the voids.

The 'Zero init' plot is the top plot (with the highest continuity error), the 'Large void' init is the middle plot and the 'Small void init' is the lowest plot. Thus convergence is faster in both the calculations using data from the void calculation as initial data for the block calculation. The convergence is better when the void sits more tightly around the block.

### (2). Solid replacement

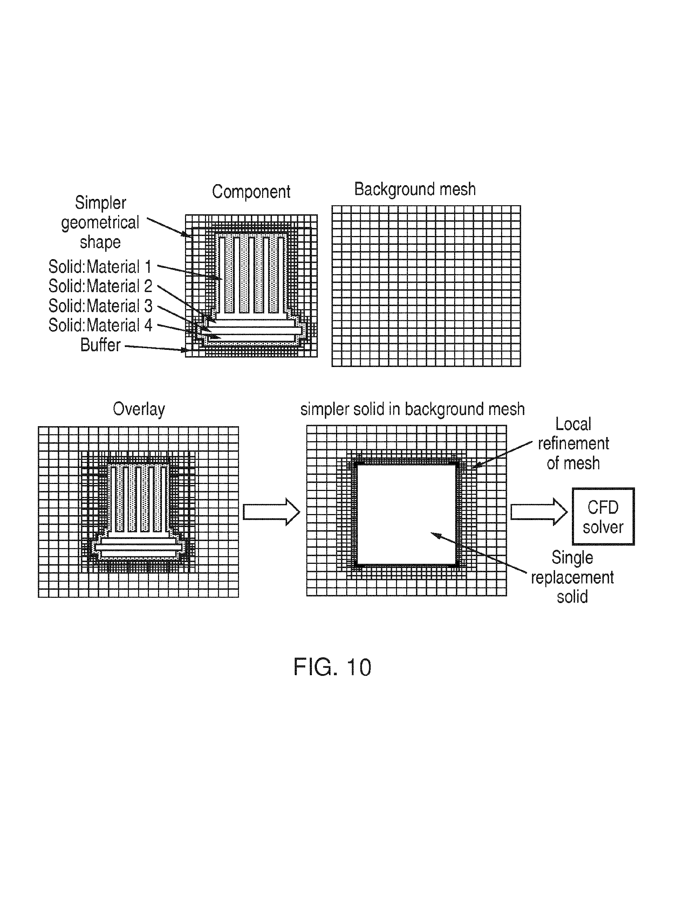

In this version of generating the simplified overall model, components are replaced by simple solids within the background mesh. A complicated component consisting of multiple parts (possibly made of materials with different thermal properties) can be replaced by a single "representative" object, as illustrated in Figure 10. In order to generate the starting configuration for the background mesh, this can allow inclusion of some of the thermal properties (e.g. as in a coupled heat transfer calculation), but with a significantly simpler geometry. The solid used to replace the detailed component is given effective thermal properties to capture the effects of the component on the flow. If supported by the CFD solver, the background mesh can be adapted around the simpler solid to better follow its shape.

For stationary parts (the majority of cases), the u=0 boundary condition will generally apply when the component is replaced. If moving parts are required, the user will need to specify the boundary conditions, and the boundary conditions will be the same whether the detailed versions of the components are being used or whether simplified representations of the components are being used.

An advantage of the solid replacement procedure is that a complicated thermal component can be replaced by a much simpler one, meaning that the mesh required in the calculation can be much coarser.

### (3). Other comments

In general, the quality of the background mesh must be sufficient to capture the interaction between the components well enough to allow convergence of the coupled simulation. This also applies in generating an improved starting flow in the background mesh using the invention embodiments. It is possible that the starting flow could be worse in relation to the converged flow than, for example, a uniform velocity profile across the background mesh. This could happen for instance if several components are placed in a line parallel to the direction of airflow from a chamber inlet, and there is a long tail of influence in the fluid flow to the presence of an obstacle, e.g. for flow around a cylinder. In such a case, the mesh may need to be refined in the regions between the voids replacing those components.

Typical cases to which the strategy described here can be applied are finite element and finite difference type calculations. In both of these cases, refinement of the background mesh near the void should generally be possible. The finite element case has the advantage that when such a refinement is performed, only the cells in the background mesh near the void need be changed; in the finite difference case, refinement of the grid spacing can be made, though this will propagate to the boundaries of the background mesh (and so is expected to be less efficient).

As mentioned previously, an alternative way to implement the strategy would be to use a flow resistance, or internal boundary condition, if this is supported by the CFD code being used.

### Benefits of Invention Embodiments

In a multi-component CFD simulation, many iterations may be required to reach convergence. The embodiments described can allow automatic generation of an improved starting point for the flow in the background mesh. This will improve the stability of the simulation, as well as reducing the number of iterations needed to reach convergence.

Thus some benefits of invention embodiments are:
1. Stability: As the CFD calculation on the background mesh is expected to now broadly contain the features of a flow around "generic" objects of similar size to the actual components, the starting point for flow in the background mesh is closer to the final solution, so introduction of the details of the components (via coupling) results in smaller perturbations, and so enhanced stability in the coupling iterations.
2.As the broad characteristics of the flow in the background mesh are built into the
   starting guess in the approach suggested here, the difference between the starting flow and the final converged flow in the background mesh will be significantly reduced.
3. Generation of the improved starting point for the flow in the background mesh (either using voids or a simple thermal component) can be performed automatically by the simulation system, meaning no input from the user is required.

## Claims

1. A method of preparation of a Computational Fluid Dynamics (CFD) model of a multi-component product including a plurality of individual components for simulation, the method including
providing a simplified model employing a simplified obstacle to fluid flow in place of one or more components in the model;
solving the simplified model; and
using the solution of the simplified model to add to modelling data by providing starting values for fluid flow in the simulation of the CFD model.

2. A method according to claim 1, wherein the provision of the simplified model and simplified model solution are carried out automatically when the multi-component product model is built.

3. A method according to claim 1 or 2, wherein the CFD model is meshed using a compound mesh comprising a background mesh and separate meshes for the components, and wherein the starting values for fluid flow are for background mesh flow.

4. A method according to any of the preceding claims, wherein the simplified model is meshed using at least a background mesh and solved by iterative calculations, with the background mesh solution providing the starting values for fluid flow in the CFD model simulation.

5. A method according to claim 3 or 4, wherein the simplified obstacle is stored before the multi-component product model is built, with the component and a mesh for the component and optionally any mesh required for the simplified obstacle.

6. A method according to any of claims 3 to 5, wherein the starting values for fluid flow in the CFD model simulation are interpolated onto the boundaries of the component mesh from the background mesh.

7. A method according to any of claims 3 to 6, wherein the background mesh is refined during the provision of the simplified model to contour around the simplified obstacle so that the background mesh more faithfully represents the simplified obstacle than before refinement, wherein for finite element simulation, the refinement is local to the simplified obstacle.

8. A method according to any of the preceding claims, wherein a simplified obstacle comprises a mesh void, the mesh void preferably encompassing the solid part of the component.

9. A method according to claim 8, wherein the mesh void is formed by encapsulating the component in a solid geometric shape and using the solid geometric shape to create the void.

10. A method according to any of the preceding claims, wherein a simplified obstacle comprises a replacement component with a simpler geometry than the component geometry, the replacement component preferably covering a part only of a component mesh.

11. A method according to claim 10, wherein the replacement component has simplified thermal properties representing more complex thermal properties of the component in the model, such as an average heat capacity equivalent to that of the component in the model.

12. A method according to claim 10 or 11, wherein any components comprising more than one sub-component are replaced by a single replacement component.

13. A method according to any of claims 8 to 12, wherein a velocity boundary condition of zero velocity is set on the edges of the void and/or replacement component for solution of the simplified model.

14. A method according to claim 3 and any of claims 10 to 13, wherein the simplified model is meshed using a compound mesh comprising the background mesh and a separate mesh for each replacement component.

15. A computer apparatus arranged to implement a method of preparation of a CFD model of a multi-component product including a plurality of individual components for simulation, the apparatus including
a model simplifier arranged to provide a simplified model employing a simplified obstacle to fluid flow in place of one or more components in the model;
at least one initialisation solver arranged to solve the simplified model; and
a data inputter arranged to use the solution of the simplified model by adding starting values for fluid flow to modelling data for the simulation of the CFD model.

16. A computer apparatus arranged to implement a method of simplifying CFD pre-processing for a range of multi-component products, each product including a different combination of a plurality of components provided for the range, the computer apparatus including
an input for a Computer Aided Design CAD model of component geometry;
a library interface and library processor allowing a library user to add an air region around the component; to create a mesh including the component and its surrounding air region for use in CFD analysis; and to create a simplified obstacle to fluid flow for use in an initialisation process to provide starting values for fluid flow by solving a simplified model in which components have been replaced by simplified obstacles; and
a component library individually storing known components for the range in a database, each known component comprising the component geometry, mesh and simplified obstacle, wherein the component library allows selection and placing of the known components to create models of the products.

## Amended claims

### Amended claims in accordance with Rule 137(2) EPC.

**1.** A method of preparation of a Computational Fluid Dynamics (CFD) model of a multi-component product including a plurality of individual components for simulation, the method including
providing (S100) a simplified model employing a simplified obstacle to fluid flow in place of one or more components in the model to fill the region of space occupied by the one or more components, wherein the simplified obstacle has a simpler geometric shape than the one or more components;
solving (S200) the simplified model; and
using (S300) the solution of the simplified model to add to modelling data by providing starting values for fluid flow in the simulation of the CFD model.

**2.** A method according to claim 1, wherein the provision of the simplified model (S100) and simplified model solution (S200) are carried out automatically when the multi-component product model is built.

**3.** A method according to claim 1 or 2, wherein the CFD model is meshed using a compound mesh comprising a background mesh and separate meshes for the components, and wherein the starting values for fluid flow are for background mesh flow.

**4.** A method according to any of the preceding claims, wherein the simplified model is meshed using at least a background mesh and solved by iterative calculations, with the background mesh solution providing the starting values for fluid flow in the CFD model simulation.

**5.** A method according to claim 3 or 4, wherein the simplified obstacle is stored before the multi-component product model is built, with the component and a mesh for the component and optionally any mesh required for the simplified obstacle.

**6.** A method according to any of claims 3 to 5, wherein the starting values for fluid flow in the CFD model simulation are interpolated onto the boundaries of the component mesh from the background mesh.

**7.** A method according to any of claims 3 to 6, wherein the background mesh is refined during the provision of the simplified model (S100) to contour around the simplified obstacle so that the background mesh more faithfully represents the simplified obstacle than before refinement, wherein for finite element simulation, the refinement is local to the simplified obstacle.

**8.** A method according to any of the preceding claims, wherein a simplified obstacle comprises a mesh void, the mesh void preferably encompassing the solid part of the component.

**9.** A method according to claim 8, wherein the mesh void is formed by encapsulating the component in a solid geometric shape and using the solid geometric shape to create the void.

**10.** A method according to any of the preceding claims, wherein a simplified obstacle comprises a replacement component with a simpler geometry than the component geometry, the replacement component preferably covering a part only of a component mesh.

**11.** A method according to claim 10, wherein the replacement component has simplified thermal properties representing more complex thermal properties of the component in the model, such as an average heat capacity equivalent to that of the component in the model.

**12.** A method according to claim 10 or 11, wherein any components comprising more than one sub-component are replaced by a single replacement component.

**13.** A method according to any of claims 8 to 12, wherein a velocity boundary condition of zero velocity is set on the edges of the void and/or replacement component for solution of the simplified model.

**14.** A method according to claim 3 and any of claims 10 to 13, wherein the simplified model is meshed using a compound mesh comprising the background mesh and a separate mesh for each replacement component.

**15.** A computer apparatus arranged to implement a method of preparation of a CFD model of a multi-component product including a plurality of individual components for simulation, the apparatus including
a model simplifier arranged to provide a simplified model employing a simplified obstacle to fluid flow in place of one or more components in the model to fill the region of space occupied by the one or more components, wherein the simplified obstacle has a simpler geometric shape than the one or more components;
at least one initialisation solver arranged to solve the simplified model; and
a data inputter arranged to use the solution of the simplified model by adding starting values for fluid flow to modelling data for the simulation of the CFD model.

**16.** A computer apparatus according to claim 1, further arranged to implement a method of simplifying CFD pre-processing for a range of multi-component products, each product including a different combination of a plurality of components provided for the range, the computer apparatus including
an input for a Computer Aided Design CAD model of component geometry;
a library interface and library processor allowing a library user to add an air region around the component; to create a mesh including the component and its surrounding air region for use in CFD analysis; and to create the simplified obstacle; and
a component library individually storing known components for the range in a database, each known component comprising the component geometry, mesh and simplified obstacle, wherein the component library allows selection and placing of the known components to create models of the products.
